(19) Europäisches Patentamt
European Patent Office
Office européen des brevets

(11) Veröffentlichungsnummer: **0 329 009**
**A2**

(12) # EUROPÄISCHE PATENTANMELDUNG

(21) Anmeldenummer: **89102201.4**

(51) Int. Cl.⁴: **G03F 7/10**

(22) Anmeldetag: **09.02.89**

(30) Priorität: **16.02.88 DE 3804765**

(43) Veröffentlichungstag der Anmeldung:
**23.08.89 Patentblatt 89/34**

(84) Benannte Vertragsstaaten:
**AT BE CH DE FR GB IT LI NL**

(71) Anmelder: **BASF Aktiengesellschaft**
**Carl-Bosch-Strasse 38**
**D-6700 Ludwigshafen(DE)**

(72) Erfinder: **Lauke, Harald, Dr.**
**Sophienstrasse 10**
**D-6800 Mannheim 1(DE)**
Erfinder: **Seitz, Friedrich, Dr.**
**Von-Wieser-Strasse 1**
**D-6701 Friedelsheim(DE)**

(54) **Lichtempfindliche, negativ arbeitende Aufzeichnungsschicht.**

(57) Die Erfindung betrifft lichtempfindliche, negativ arbeitende, zur Herstellung von Resistmustern geeignete, wäßrig-alkalisch entwickelbare Aufzeichnungsschichten.

Diese bestehen im wesentlichen aus einem Gemisch aus

a) einem oder mehreren in Wasser unlöslichen, in wäßrig-alkalischen Lösungen jedoch löslichen oder zumindest dispergierbaren filmbildenden polymeren Bindemitteln,

b) einer oder mehreren photopolymerisierbaren organischen monomeren Verbindungen mit mindestens einer ethylenisch ungesättigten Doppelbindung oder deren Gemisch mit ethylenisch ungesättigten oligomeren Verbindungen,

c) einem Photoinitiator oder Photoinitiatorsystem und

d) üblichen Zusatz- und Hilfsstoffen,

wobei das Gemisch zusätzlich ein Silan oder das bei der Hydrolyse des Silans entstehende Produkt oder Produktgemisch enthält.

EP 0 329 009 A2

## Lichtempfindliche, negativ arbeitende Aufzeichnungsschicht

Die Erfindung betrifft eine lichtempfindliche, negativ arbeitende, zur Herstellung von Resistmustern für gedruckte Schaltungen geeignete, wäßrig-alkalisch entwickelbare Aufzeichnungsschicht, die verringerte Neigung zur Restschichtbildung aufweist.

Photoresiste für die Herstellung von Leiterplatten sind aus zahlreichen Patentschriften bekannt (z.B. DE-A-34 47 356, EP-A-2805, EP-A-186 844 und EP-A-194 440). Wäßrig-alkalisch entwickelbare Photoresiste weisen Vorteile hinsichtlich der Umweltbelastung und der Investitionskosten für den Anwender auf. Sie enthalten im allgemeinen ein oder mehrere sauer funktionalisierte Bindemittel, deren funktionelle Gruppen, meist Carboxylgruppen, in der Regel auch die Haftung zum Kupfersubstrat sicherstellen. Werden jedoch während des Herstellungsprozesses die Leiterplatten zwischen Laminieren und Entwickeln einige Tage oder Wochen gelagert, so kommt es häufig zur Bildung einer Restschicht an der Kupferoberfläche, die sich auch durch wiederholtes Entwickeln nicht entfernen läßt. Platten mit Restschichten müssen ausgesondert werden, weil die Oberfläche weiteren Verfahrensschritten wie Ätzen oder Galvanik nicht mehr zugänglich ist.

In der Vergangenheit wurden zahlreiche Zusätze zu Photoresistfilmen beschrieben, die die Haftung zu Kupfer verbessern und gleichzeitig die Bildung einer Restschicht verhindern sollen (vgl. z.B. DE-A-20 63 571, DE-A-36 00 442, EP-A-193 621 und US-A-4 629 679). Die als Zusätze zur Haftungsverbesserung oder Restschichtverhinderung beschriebenen Verbindungen weisen jedoch den Nachteil auf, daß sie im Verlauf einzelner Verfahrensschritte während der Leiterplattenfertigung, insbesondere in den Galvanikbädern, partiell oder vollständig extrahiert werden und dann wegen ihrer komplexierenden Eigenschaften zu einer Störung der Metallabscheidung führen.

Aufgabe der vorliegenden Erfindung war es daher, eine wäßrig-alkalisch entwickelbare Photoresistschicht für die Fertigung von gedruckten Schaltungen zu entwickeln, die auch nach längerer Lagerung unter den in der Leiterplattenfertigung üblichen Bedingungen keine Restschicht ausbildet und nicht zu Störungen in der Galvanik führt.

Überraschenderweise läßt sich diese Aufgabe in besonders vorteilhafter Weise durch Zusatz eines Silans oder des bei der Hydrolyse dieses Silans entstehenden Produktes lösen.

Gegenstand der vorliegenden Erfindung ist eine lichtempfindliche, negativ arbeitende, zur Herstellung von Resistmustern geeignete, wäßrig-alkalisch entwickelbare Aufzeichnungsschicht, die im wesentlichen besteht aus einem Gemisch aus

a) einem oder mehreren in Wasser unlöslichen, in wäßrig-alkalischen Lösungen jedoch löslichen oder zumindest dispergierbaren filmbildenden polymeren Bindemitteln,

b) einer oder mehreren photopolymerisierbaren organischen monomeren Verbindungen mit mindestens einer ethylenisch ungesättigten Doppelbindung, die gegebenenfalls teilweise durch eine oder mehrere oligomere Verbindungen mit mindestens einer ethylenisch ungesättigten Doppelbindung ersetzt sein können,

c) einem Photoinitiator oder Photoinitiatorsystem und

d) üblichen Zusatz- und Hilfsstoffen,

wobei dieses Gemisch dadurch gekennzeichnet ist, daß es zusätzlich ein Silan oder das bei der Hydrolyse des Silans entstehende Produkt oder Produktgemisch enthält.

Erfindungsgemäß eignen sich insbesondere Silane der allgemeinen Formel (I)

$X\text{-}(CH_2)_y\text{-}Si(R^1)_n(OR^2)_{3\text{-}n}$ (I),

worin $R^1$ und $R^2$ untereinander gleich oder verschieden sind und für Alkylreste mit 1 bis 9 Kohlenstoffatomen oder für Arylreste mit 6 bis 12 Kohlenstoffatomen stehen und X für einen der Reste

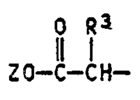 , 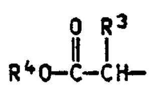 , 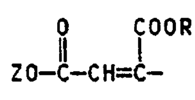 , 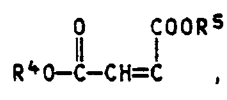 , 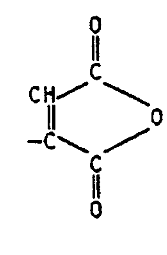 ,

$(R^5O)_2\overset{O}{\overset{\|}{P}}$-, $(Hal)_2\overset{O}{\overset{\|}{P}}$-, $ZO_3S$-, $HalO_2S$-, $ZO_3S$-Ar-, $HalO_2S$-Ar-, $R^5CH{=}CH\text{-}\overset{O}{\overset{\|}{C}}\text{-}O$-,

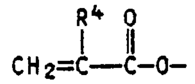 , 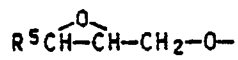 ,

$R^5NH-(CH_2)_sNH-$ oder $[R^5NH_2-(CH_2)_s\ NH \overset{\oplus}{-}\ ]A^{\ominus}$ steht, wobei $R^3$ für Wasserstoff, einen Alkylrest mit 1 bis 9 Kohlenstoffatomen, einen Carbonsäurerest mit 1 bis 9 Kohlenstoffatomen oder einen aus diesem Carbonsäurerest und dem an $R^3$ gebundenen

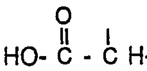 H-Rest

gebildeten Carbonsäureanhydridring steht,
$R^4$ für einen Alkylrest mit 1 bis 9 Kohlenstoffatomen oder einen Arylrest mit 6 bis 12 Kohlenstoffatomen steht,
$R^5$ für Wasserstoff, einen Alkylrest mit 1 bis 9 Kohlenstoffatomen oder einen Arylrest mit 6 bis 12 Kohlenstoffatomen oder einen Benzylrest steht,
Z für Wasserstoff oder ein Alkalimetall,
Ar für einen Arylenrest mit 6 bis 12 Kohlenstoffatomen,
Hal für Chlor oder Brom,
$A^{\ominus}$ für ein einwertiges anorganisches Anion, wie z.B. Halogenid, wie $Cl^{\ominus}$ und $Br^{\ominus}$, oder $HSO_4^{\ominus}$,
s für eine ganze Zahl von 1 bis 6,
y für eine ganze Zahl von 1 bis 4 und
n = 0, 1 oder 2
stehen, oder die bei der Hydrolyse dieser Silane entstehenden Produkte oder Produktgemische.

Die erfindungsgemäßen Aufzeichnungsschichten enthalten das Silan oder das bei der Hydrolyse eines Silans entstehende Produkt oder Produktgemisch im allgemeinen in einer Konzentration von 0,01 bis 10 %, vorzugsweise von 0,05 bis 5 %, bezogen auf das Trockengewicht der Aufzeichnungsschicht.

Beispiele für bevorzugte Silane sind (2-Tripropoxysilylethyl)carbonsäure, (3-Tripropoxysilylpropyl)-carbonsäure, (4-Tripropoxysilylbutyl)carbonsäure sowie deren Methyl-, Ethyl-, Propyl- und Butylester, (3-Triethoxysilylpropyl)bernsteinsäureanhydrid, (3-Triethoxysilylpropyl)maleinsäureanhydrid, Glycidoxypropyltrimethoxysilan, Glycidoxypropyltriethoxysilan, (2-Trimethoxysilylethyl)phosphonsäuredimethylester, (3-Triethoxysilylpropyl)phosphonsäuredimethylester und -phosphonsäurediethylester, (Trimethoxysilylmethyl)-phosphonsäuredichlorid, (3-Trimethoxysilylpropyl)phosphonsäuredichlorid, (3-Trimethoxysilylpropyl)-phosphonsäure, 2-(4-Chlorosulfonylphenyl)ethyltrimethoxysilan, 2-(4-Sulfonylphenyl)ethyltrimethoxysilan, (3-Trimethoxysilylpropyl)sulfonsäurechlorid, (3-Trimethoxysilylpropyl)sulfonsäure, (3-Trimethoxysilylpropyl)-acrylat und -methacrylat, (3-Trimethoxysilylpropyl)ethylendiamin und [(3-Trimethoxysilylpropylamino)ethyl]-(benzyl)ammoniumchlorid sowie deren Hydrolyseprodukte.

Besonders bevorzugte Silane sind (3-Trimethoxysilylethyl)phosphonsäuredimethylester und -diethylester, (3-Triethoxysilylpropyl)bernsteinsäureanhydrid, Glycidoxypropyltrimethoxysilan, Glycidoxypropyltriethoxysilan, (3-Trimethoxysilylpropyl)acrylat und -methacrylat, (3-Trimethoxysilylpropyl)ethylendiamin und [(3-Trimethoxysilylpropylamino)ethyl](benzyl)ammoniumchlorid sowie deren Hydrolyseprodukte.

Zu den anderen Komponenten des erfindungsgemäß einzusetzenden Gemisches ist im einzelnen folgendes auszuführen.

a) Als in Wasser unlösliche, in wäßrig-alkalischen Lösungen jedoch lösliche oder zumindest dispergierbare polymere Bindemittel kommen carboxylgruppenhaltige oder Carbonsäureanhydrid-Gruppen enthaltende Copolymerisate in Betracht, wie z.B. Styrol/Maleinsäureanhydrid-Copolymerisate, Styrol/Maleinsäurehalbester-Copolymerisate, Alkyl(meth)acrylat/(Meth)acrylsäure-Copolymerisate, Copolymerisate aus Styrol, Alkyl(meth)acrylaten und (Meth)acrylsäure sowie gegebenenfalls anderen Monomeren (vgl. u.a. DE-B-20 27 467, DE-A-22 05 146, EP-A-49 504 oder DE-A-27 36 058) oder Copolymerisate, die Acrylsäure und/oder Methacrylsäure, hydrophobe Comonomere und N-Vinylamide einpolymerisiert enthalten, wie sie beispielsweise in DE-A-34 47 356 beschrieben sind. Derartige Copolymerisate können beispielsweise 10 bis 50 Gew.% eines Vinylamids, wie z.B. N-Vinylformamid, N-Vinylacetamid, N-Vinyl-N-Methylacetamid oder N-Vinyllactame, wie N-Vinylpyrrolidon und/oder N-Vinylcaprolactam, 5 bis 30 Gew.% Acrylsäure und/oder Methacrylsäure sowie 30 bis 80 Gew.% mindestens eines hydrophoben Comonomeren, welches als solches in Wasser und wäßrig-alkalischen Lösungen unlösliche Homopolymerisate bildet, einpolymerisiert enthalten.

Als Beispiele für die letztgenannten hydrophoben Comonomeren seien genannt: Vinylaromaten, wie z.B. Styrol, substituierte Styrole, die in der Seitenkette oder im Kern beispielsweise durch Alkylgruppen oder Halogenatome substituiert sind, wie α-Methylstyrol, p-Methylstyrol und dergleichen, Vinylacetat sowie die

Ester der Acrylsäure und Methacrylsäure, insbesondere die Acrylate und Methacrylate von geradkettigen oder verzweigten Monoalkanolen, vorzugsweise mit 1 bis 4 C-Atomen, wobei hierunter unter anderem das Methylmethacrylat besonders günstig ist. Das Copolymerisat kann ein oder mehrere der hydrophoben Comonomeren einpolymerisiert enthalten, wobei der Anteil der hydrophoben Comonomer-Einheiten in dem Copolymerisat 30 bis 80 Gew.%, vorzugsweise 40 bis 70 Gew.%, bezogen auf das Copolymerisat, betragen kann.

Beispiele für Copolymerisate für den Einsatz als polymeres Bindemittel in den lichtempfindlichen Aufzeichnungsschichten sind u.a. N-Vinyllactam/(Meth)acrylsäure/Methylmethacrylat-Copolymerisate oder N-Vinyllactam/(Meth)acrylsäure/Styrol-Copolymerisate. In einer typischen Ausführungsform können diese Copolymerisate die Comonomeren beispielsweise in Mengen von 25 bis 35 Gew.% an N-Vinylcaprolactam und/oder N-Vinylpyrrolidon, 5 bis 15 Gew.% an (Meth)acrylsäure und 55 bis 65 Gew.% an den hydrophoben Comonomeren, jeweils bezogen auf das Copolymerisat, einpolymerisiert enthalten.

Beispiele für weitere geeignete polymere Bindemittel (a) sind Styrol(Meth)-acrylsäure/Methylmethacrylat/Ethylacrylat-Copolymerisate, die z.B. 10 bis 40 % Styrol, 20 bis 30 % Methacrylsäure, 5 bis 50 % Methylmethacrylat und 0 bis 50 % Ethylacrylat einpolymerisiert enthalten.

Die Comonomeren für die einzusetzenden Copolymerisate (a) werden nach Art und Menge in dem vorstehend angegebenen allgemeinen Rahmen so ausgewählt, daß die Copolymerisate filmbildend sind und die an sie gestellten Forderungen bezüglich ihrer Löslichkeit bzw. Dispergierbarkeit erfüllen. Gegebenenfalls können auch Gemische geeigneter carboxylgruppenhaltiger Copolymerisate eingesetzt werden.

Die als polymeres Bindemittel einzusetzenden Copolymerisate können nach den an sich bekannten und üblichen Polymerisationsmethoden durch Copolymerisation der Comonomeren, beispielsweise in Lösung, hergestellt werden. Für die Lösungspolymerisation eignen sich z.B. niedere Alkanole, Ketone, Ester und ähnliche, wie Methanol, Aceton, Methylethylketon, Ethylacetat etc., als Lösungsmittel. Als Polymerisationsinitiatoren kommen die üblichen radikalischen Starter, wie beispielsweise Azobisisobutyronitril, Benzoylperoxid und dergleichen in Betracht.

Das polymere Bindemittel (a) ist in der lichtempfindlichen Aufzeichnungsschicht im allgemeinen in einer Menge von 1 bis 90 %, vorzugsweise 20 bis 70 Gew.%, bezogen auf Gesamtgewicht der Aufzeichnungsschicht enthalten.

Neben dem polymeren Bindemittel (a) enthält die lichtempfindliche Aufzeichnungsschicht im allgemeinen mindestens eine ethylenisch ungesättigte, photopolymerisierbare Verbindung (b), mindestens einen Photopolymerisationsinitiator bzw. ein Photopolymerisationsinitiatorsystem (c) sowie gegebenenfalls weitere Zusatz- und/oder Hilfsstoffe (d) zur Verbesserung und/oder Modifizierung der allgemeinen Eigenschaften der lichtempfindlichen Aufzeichnungselemente oder Resistmuster.

b) Als photopolymerisierbare organische monomere Verbindungen mit mindestens einer ethylenisch ungesättigten Doppelbindung kommen die üblichen ethylenisch ungesättigten photopolymerisierbaren Monomeren in Betracht, vorzugsweise solche mit Siedepunkten über 100 °C und Molekulargewichten < 1000. Diese Monomeren können teilweise durch eine oder mehrere oligomere Verbindungen mit mindestens einer ethylenisch ungesättigten Doppelbindung ersetzt sein, wobei die Molekulargewichte dieser Oligomeren im allgemeinen im Bereich zwischen 1000 und 10.000, vorzugsweise zwischen 1500 und 6000 liegen können.

Die photopolymerisierbaren Monomeren und Oligomeren können dabei sowohl mono- als auch polyfunktionell sein, d.h. eine oder mehrere photopolymerisierbare, ethylenische Doppelbindungen besitzen. Üblicherweise sind in der photopolymerisierbaren Aufzeichnungsschicht bi- oder mehrfunktionelle ethylenisch ungesättigte, photopolymerisierbare Verbindungen allein oder Mischungen hiervon mit einem untergeordneten Anteil an monofunktionellen ethylenisch ungesättigten, photopolymerisierbaren Verbindungen enthalten.

Als Vertreter für die photopolymerisierbaren Monomeren seien insbesondere die Derivate der (Meth)-acrylsäure und ganz besonders die (Meth)acrylsäureester genannt. Beispiele hierfür sind die Di- und Tri-(meth)acrylate von Ethylenglykol, Diethylenglykol, Triethylenglykol oder Polyethylenglykolen mit einem Molekulargewicht bis etwa 500, 1,2-Propandiol, 1,3-Propandiol, Polypropylenglykolen mit einem Molekulargewicht bis etwa 500, 1,4-Butandiol, 1,1,1-Trimethylolpropan, 2,2-Dimethylpropandiol, Glycerin oder Pentaerythrit; Pentaerythrittetra(meth)acrylat, Glucosetri- oder tetra-(meth)acrylat, ferner die Monoacrylate und Monomethacrylate der genannten Diole und Polyole, wie z.B. Ethylenglykol-, Di-, Tri- oder Tetraethylenglykolmono(meth)acrylat, Propandiol-mono(meth)acrylat und Butandiol-mono(meth)acrylat und die (Meth)acrylate von Monoalkanolen, insbesondere von solchen mit 1 bis 20 C-Atomen. Neben den bevorzugten Acrylaten und Methacrylaten der vorstehend genannten Art seien als photopolymerisierbare Monomere auch die Allyl-Verbindungen und andere Vinyl-Verbindungen genannt, wie z.B. N-Vinylpyrrolidon, N-Vinylcaprolactam, Vinylacetat, Vinylpropionat, (Meth)acrylamid, N-Methylol-(meth)acrylamid, der Bisether des Ethylenglykols und N-Methylol-(meth)acrylamids, Vinylcarbamate, Bisacrylamidoessigsäure,

Glyoxalbisamid und andere.

Geeignete ethylenisch ungesättigte, photopolymerisierbare Verbindungen für die erfindungsgemäßen lichtempfindlichen Aufzeichnungsschichten sind auch die monomeren Urethanacrylate bzw. -methacrylate mit zwei oder mehr Acryloyl- und/oder Methacryloyl-Gruppen. Solche monomeren Urethan(meth)acrylate können beispielsweise erhalten werden durch Umsetzung von aliphatischen Di- oder Polyolen mit organischen Diisocyanaten in einem Äquivalentverhältnis OH:NCO von etwa 1:2 und anschließende Umsetzung der freien Isocyanatgruppen des erhaltenen Reaktionsproduktes mit geeigneten Acryloyl- und/oder Methacryloyl-Verbindungen, beispielsweise Hydroxyalkyl-(meth)acrylaten. Als aliphatische Di- oder Polyole kommen unter anderem die vorstehend im Zusammenhang mit den Di- und Tri(meth)acrylaten genannten Di- und Polyhydroxy-Verbindungen in Betracht; als Beispiele für organische Diisocyanate seien Hexamethylendiisocyanat, Toluylendiisocyanat, Isophorondiisocyanat und ähnliche genannt; Hydroxyalkyl(meth)acrylate sind beispielsweise Hydroxyethyl-(meth)acrylat, Propandiol-mono(meth)acrylat oder Butandiol-mono(meth)-acrylat. Ebenso geeignet und vorteilhaft sind Monomere mit zwei oder mehr Acryloyl- und/oder Methacryloyl-Gruppen, wie sie beispielsweise erhalten werden können durch Umsetzung von Di- oder Polyglycidylverbindungen mit Acrylsäure und/oder Methacrylsäure. Als Di- und Polyglycidylverbindungen kommen hier insbesondere die Di- und Polyglycidylether mehrwertiger Phenole, beispielsweise des Bisphenols A oder der Substitutionsprodukte von Bisphenol A, in Betracht. Beispielhaft für solche Acryloyl- und/oder Methacryloyl-Gruppen enthaltenden Monomeren seien die Umsetzungsprodukte des Bisphenol A-bisglycidylethers mit Acryl- und/oder Methacrylsäure im molaren Verhältnis von etwa 1:2 hervorgehoben.

Als vorteilhaft für die Herstellung von Resistmustern hat es sich erwiesen, wenn die lichtempfindlichen Aufzeichnungsschiohten als photopolymerisierbare Verbindung Oligomere mit 2 oder vorzugsweise mehr als 2 Acryloyl- und/oder Methacryloyl-Gruppen enthalten. Hierbei kann es sich beispielsweise um Acryloyl- und/oder Methacryloyl-Gruppen enthaltende oligomere Urethan-Harze oder um solche auf Basis von Di- oder Polyepoxiden handeln, wie sie als solche bekannt und in der Literatur beschrieben sind, wie z.B. solche Oligomeren die neben den Acryloyl- und/oder Methacryloyl-Gruppen zusätzlich noch freie Carboxylgruppen im Molekül enthalten. Die Oligomeren können so Säurezahlen im Bereich von 50 bis 150 mg KOH/g aufweisen. Geeignete photopolymerisierbare Oligomere dieser Art sind z.B. in der DE-A-24 42 527, der DE-C-25 57 408 oder auch der DE-A-29 17 483 beschrieben. Weitere photopolymerisierbare Oligomere können beispielsweise hergestellt werden, indem man die Hydroxylgruppen einer Acryloyl- und/oder Meth acryloyl-Gruppen enthaltenden Diol- oder Polyol-Verbindung derart mit mehrfachen Carbonsäuren oder deren Derivaten, insbesondere cyclischen Carbonsäureanhydriden, umsetzt, daß sich die sauren Teilester der mehrfachen Carbonsäuren bilden, und anschließend einen Teil der freien Carboxylgruppen des so erhaltenen Reaktionsprodukts unter Kettenverlängerung sowie gegebenenfalls Verzweigung mit Di- und/oder Polyepoxiden umsetzt. Die Acryloyl- und/oder Methacryloyl-Gruppen enthaltenden Diol- oder Polyol-Verbindungen, die als Ausgangsprodukt für die Herstellung solcher Oligomeren dienen, werden zweckmäßigerweise hergestellt, indem man Di- oder Polyepoxid-Verbindungen, wie z.B. Di- oder Polyglycidylether bzw. Di- oder Polyglycidylester mit Acrylsäure und/oder Methaycrylsäure im Äquivalentverhältnis Glycidyl-Gruppen:COOH-Gruppen von etwa 1:1 umsetzt. Die Di- oder Polyepoxid-Verbindungen können dabei auch beispielsweise vor oder während der Umsetzung mit der (Meth)acrylsäure durch Umsetzung mit Dicarbonsäuren vorverlängert werden. Beispielhaft und stellvertretend für Oligomere der letztgenannten Art seien die Produkte genannt, wie sie erhältlich sind durch Umsetzung von Bisphenol A-bisglyoidylether mit Acryl- und/oder Methacrylsäure bzw. mit einem Gemisch aus etwa 30 bis 70 Mol.% einer Dicarbonsäure, beispielsweise Adipinsäure, und etwa 30 bis 70 Mol.% Acryl- und/oder Methacrylsäure im Äquivalentverhältnis Glycidyl-Gruppen:Gesamt-COOH von etwa 1:1, Umsetzung der Hydroxyl-Gruppen des so erhaltenen Reaktionsproduktes mit einem cyclischen Dicarbonsäureanhydrid, beispielsweise Phthalsäureanhydrid, gegebenenfalls in Mischung mit einem untergeordneten Anteil des Anhydrids einer anderen mehrfachen Carbonsäure, z.B. Trimellithsäureanhydrid, im Äquivalentverhältnis OH-Gruppen:Anhydrid-Gruppen von etwa 1:1 unter Bildung der sauren Teilester der mehrfachen Carbonsäuren und schließlich Umsetzung eines Teils der freien Carboxyl-Gruppen des so erhaltenen Reaktionsproduktes mit einem Di- und/oder Polyglycidylether, beispielsweise Bisphenol A-bisglycidylether oder Pentaerythrittriglycidylether, im Äquivalentverhältnis COOH-Gruppen:Glycidyl-Gruppen von größer 1:1, vorzugsweise im Bereich von etwa 1,15:1 bis 5:1. Derartige Oligomere sind beispielsweise in DE-A-34 47 355 beschrieben.

Die ethylenisch ungesättigten, photopolymerisierbaren Monomeren und deren Gemische mit Oligomeren werden dabei - für den Fachmann selbstverständlich - so gewählt, daß sie mit den als polymerem Bindemittel (a) eingesetzten Copolymerisaten verträglich sind. Das Mengenverhältnis von polymerem Bindemittel (a) zu den ethylenisch ungesättigten, photopolymerisierbaren Verbindungen (b) in der lichtempfindlichen Aufzeichnungsschicht kann in weiten Grenzen variiert werden und beispielsweise im Bereich von 1:99 bis 90:10 liegen. Ein niedriger Anteil an polymerem Bindemittel, beispielsweise im Bereich von etwa 1

bis 35 Gew.%, bezogen auf die photopolymerisierbare Aufzeichnungsschicht, kommt insbesondere dann in Betracht, wenn in der photopolymerisierbaren Aufzeichnungsschicht als ethylenisch ungesättigte, photopolymerisierbare Verbindung ein hoher Anteil, beispielsweise 40 Gew.% oder mehr und insbesondere mehr als etwa 45 Gew.%, bezogen auf die photopolymerisierbare Aufzeichnungsschicht, an einem oder mehreren, mehr als zwei Acryloyl- und/oder Methacryloyl-Gruppen sowie freie Carboxyl-Gruppen enthaltenden Oligomeren enthalten ist.

c) Als Photoinitiatoren für die lichtempfindlichen Aufzeichnungsschichten kommen die für lichtempfindliche, photopolymerisierbare Aufzeichnungsmaterialien üblichen und an sich bekannten Photoinitiatoren bzw. Photoinitiatorsysteme in Betracht. Beispielhaft seien hierfür genannt: Benzoin, Benzoinether, insbesondere Benzoinalkylether, substituierte Benzoine, Alkylether von substituierten Benzoinen, wie z.B. $\alpha$-Methylbenzoinalkylether oder $\alpha$-Hydroxymethylbenzoinalkylether; Benzile, Benzilketale, insbesondere Benzildimethylketal, Benzilmethylethylketal oder Benzilmethylbenzylketal; die als Photoinitiator bekannten und wirksamen Acylphosphinoxid-Verbindungen, wie z.B. 2,4,6-Trimethylbenzoyldiarylphosphinoxid; Benzophenon, Derivate des Benzophenons, 4,4′-Dimethylaminobenzophenon, Derivate von Michler's Keton; Anthrachinon und substituierte Anthrachinone; arylsubstituierte Imidazole oder deren Derivate, wie z.B. 2,4,5-Triarylimidazoldimere; Thioxanthonderivate und die als Photoinitiatoren wirksamen Acridin- oder Phenacin-Derivate. Beispiele für Initiatorsysteme sind Kombinationen der genannten Initiatoren mit Sensibilisierungshilfsmitteln oder Aktivatoren, wie insbesondere tertiären Aminen. Typische Beispiele für solche Initiatorsysteme sind Kombinationen aus Benzophenon oder Benzophenon-Derivaten mit tertiären Aminen, wie Triethanolamin oder Michler's Keton; oder Gemische aus 2,4,5-Triarylimidazol-Dimeren und 2-Mercaptobenzochinazol oder den Leukobasen von Triphenylmethanfarbstoffen. Die Auswahl der geeigneten Photoinitiatoren bzw. Photoinitiator-Systeme ist dem Fachmann geläufig. Die Photoinitiatoren bzw. Photoinitiatorsysteme sind in der lichtempfindlichen Aufzeichnungsschicht im allgemeinen in Mengen von 0,05 bis 5 Gew.%, bezogen auf die lichtempfindliche Aufzeichnungsschicht, enthalten.

d) Als weitere Zusatz- und/oder Hilfsstoffe (d), die in der erfindungsgemäßen lichtempfindlichen Aufzeichnungsschicht enthalten sein können, kommen z.B. thermische Polymerisationsinhibitoren, Farbstoffe und/oder Pigmente, photochrome Verbindungen bzw. Systeme, sensitometrische Regler, Weichmacher, Verlaufshilfsmittel, Mattierungs- oder Gleitmittel und dergleichen in Betracht. Geeignete thermische Polymerisationsinhibitoren sind z.B. Hydrochinon, Hydrochinon-Derivate, 2,6-Di-t.-butyl-p-cresol, Nitrophenole, N-Nitrosoamine, wie N-Nitrosodiphenylamin oder die Salze des N-Nitrosocyclohexylhydroxylamins. Beispiele für Farbstoffe und/oder Pigmente, die sowohl als Kontrastmittel als auch schichtverfestigend wirken können, sind u.a. Brilliant Green Dye (C.I. 42 040), Viktoria-Reinblau FGA, Viktoria-Reinblau BO (C.I. 42 595), Viktoria-Blau B (C.I. 44 045), Rhodamin 6 G (C.I. 45 160), Triphenylmethanfarbstoffe, Naphthalimidfarbstoffe, Azosole und 3′-Phenyl-7-dimethylamino-2,2′-spiro-di-(2H-1-benzopyran). Photochrome Systeme, die bei Belichtung mit aktinischem Licht reversibel oder irreversibel ihre Farbe ändern, ohne hierbei den Photopolymerisationsprozeß zu stören, sind z.B. Leukofarbstoffe zusammen mit geeigneten Aktivatoren. Als Beispiele für Leukofarbstoffe seien die Leukobasen der Triphenylmethanfarbstoffe, wie Kristallviolett-Leukobase und Malachitgrün-Leukobase, Leuko-Basischblau, Leuko-Pararosanilin, Leuko-Patentblau A oder V genannt; ferner kommt auch Rhodamin B-Base in Betracht. Als Aktivatoren für diese photochromen Verbindungen kommen u.a. organische Halogenverbindungen, die bei Belichtung mit aktinischem Licht Halogenradikale abspalten, oder Hexaarylbisimidazole in Betracht. Zu den sensitometrischen Reglern gehören Verbindungen wie z.B. 9-Nitroanthracen, 10,10′-Bisanthron, Phenazinium-, Phenoxazinium-, Acridinium- oder Phenothiazinium-Farbstoffe, insbesondere in Kombination mit milden Reduktionsmitteln, 1,3-Dinitrobenzole und ähnliche. Als Weichmacher können die an sich bekannten und üblichen niedermolekularen oder hochmolekularen Ester, wie Phthalate oder Adipate, Toluolsulfonamid oder Tricresylphosphat, dienen. Die Zusatz- und/oder Hilfsstoffe sind in den photopolymerisierbaren Aufzeichnungsschichten in den für diese Stoffe üblichen und bekannten wirksamen Mengen vorhanden. Ihre Menge sollte jedoch im allgemeinen 30 Gew.%, vorzugsweise 20 Gew.%, bezogen auf die lichtempfindliche Aufzeichnungsschicht, nicht überschreiten.

Das Mischungsverhältnis, in dem die einzelnen Komponenten in der lichtempfindlichen Aufzeichnungsschicht enthalten sind, wird im allgemeinen so gewählt, daß diese Aufzeichnungsschicht nicht nur wäßrig-alkalisch entwickelbar, sondern vorteilhafterweise auch bei Raumtemperatur fest und nicht klebrig ist und gute Filmbildungseigenschaften besitzt. Für den Einsatz der erfindungsgemäßen lichtempfindlichen Aufzeichnungselemente als Photoresistfilm wird die Zusammensetzung darüber hinaus so gewählt, daß die lichtempfindliche Aufzeichnungsschicht gut laminierbar und unter Anwendung von Druck sowie gegebenenfalls Wärme auf ein Substrat übertragbar ist. für die Herstellung von Resistmustern werden üblicherweise Schichtdicken der lichtempfindlichen Aufzeichnungsschicht im Bereich von etwa 1 bis 50 $\mu$m eingestellt.

Die lichtempfindliche Aufzeichnungsschicht kann zum Beispiel aus einer homogenen, filmbildenden und

in wäßrig-alkalischen Lösungen löslichen oder zumindest dispergierbaren Mischung von

a) 40 bis 90 Gew.% mindestens eines N-Vinylamid-Copolymerisats der vorstehend genannten Art als polymerem Bindemittel,

b) 8 bis 55 Gew.% mindestens eines ethylenisch ungesättigten, photopolymerisierbaren, mit dem bzw. den polymeren Bindemitteln verträglichen Monomeren, bei hohen Monomer-Gehalten gegebenenfalls auch in Mischung zusammen mit einer untergeordneten Menge an einem oder mehreren, verträglichen, photopolymerisierbaren Oligomeren,

c) 0,05 bis 5 Gew.% mindestens eines Photopolymerisationsinitiators sowie

d) 0 bis 30 Gew.%, vorzugsweise 0,05 bis 20 Gew.%, an weiteren, die allgemeinen Eigenschaften der Aufzeichnungselemente bzw. der hieraus hergestellten Druckformen oder Resistmuster verbessernden bzw. modifizierenden Zusatz- und/oder Hilfsstoffen bestehen,

wobei dieses Gemisch erfindungsgemäß zusätzlich 0,01 bis 10, insbesondere 0,05 bis 5 Gew.% eines Silans der allgemeinen Formel (I) oder das bei der Hydrolyse des Silans entstehende Produkt enthält.

Die Silan-haltigen lichtempfindlichen Aufzeichnungsschichten können auch weniger als 40 Gew.%, bezogen auf die photopolymerisierbare Aufzeichnungsschicht, des oder der polymeren Bindemittel (a) enthalten, wenn sie neben Photoinitiator sowie gegebenenfalls weiteren Zusatz- und/oder Hilfsstoffen, mindestens 40 Gew.%, vorzugsweise 45 bis 75 Gew.%, bezogen auf die photopolymerisierbare Aufzeichnungsschicht, an einem oder mehreren, in wäßrig-alkalischen Lösungen löslichen oder zumindest dispergierbaren Oligomeren mit mehr als zwei ethylenischen, photopolymerisierbaren Doppelbindungen, insbesondere Acryloyl- und/oder Methacryloyl-Gruppen, sowie vorzugsweise freien Carboxyl-Gruppen und mit einem mittleren Molekulargewicht (Zahlenmittel) im Bereich von etwa 1000 bis 10.000 und photopolymerisierbare Monomere, insbesondere in einer Menge von etwa 1 bis 30 Gew.%, vorzugsweise von etwa 10 bis 25 Gew.%, bezogen auf die photopolymerisierbare Aufzeichnungsschicht, enthalten. Solche photopolymerisierbaren Aufzeichnungsschichten mit einem relativ geringen Anteil an polymerem Bindemittel eignen sich insbesondere für dünne Schichten, wie sie beispielsweise bei der Herstellung von Resistmustern und Photoresistfilmen zur Anwendung kommen.

Für Photoresistfilme und Schichtübertragungsmaterialien finden als Trägermaterialien vorzugsweise Kunststoff-Filme oder -Folien, insbesondere Polyester-Folien, Verwendung, die eine mäßige Haftung zu der lichtempfindlichen Aufzeichnungsschicht haben und nach dem Auflaminieren bzw. Aufkaschieren der photopolymerisierbaren Aufzeichnungsschicht auf ein Substrat von dieser - vor oder nach der Belichtung mit aktinischem Licht -abgezogen werden können. Für die Herstellung von Resistmustern kann die lichtempfindliche Aufzeichnungsschicht auch direkt auf das zu schützende sowie gegebenenfalls dauerhaft zu modifizierende Substrat aufgebracht werden, welches dann als Träger für die lichtempfindliche Aufzeichnungsschicht fungiert. Als Substrate für Photoresistschichten kommen beispielsweise Kupferbleche, kupferkaschierte Basismaterialien, Keramiksubstrate, die mit metallischen oder metalloxidischen Schichten beschichtet sind, Halbleiterelemente, Silicium-Wafer und dgl. in Betracht. Die Trägermaterialien für die lichtempfindlichen Aufzeichnungsschichten können gegebenenfalls in an sich bekannter Weise, z.B. mechanisch, chemisch, elektrochemisch und/oder durch Versehen mit einer Haftgrundierung, vorbehandelt sein. Gleichermaßen können zwischen lichtempfindlicher Aufzeichnungsschicht und Träger auch noch eine oder mehrere Zwischenschichten angeordnet sein.

Bei Photoresistfilmen und Schichtübertragungsmaterialien kann eine solche Zwischenschicht zwischen lichtempfindlicher Aufzeichnungsschicht und dem abziehbaren, temporären Schichtträger das Abziehen des Schichtträgers nach dem Auflaminieren bzw. Aufkaschieren der lichtempfindlichen Aufzeichnungsschicht auf das Substrat erleichtern und/oder als Sauerstoffsperrschicht nach dem Abziehen des Schichtträgers dienen.

Ebenso kann auf der dem Träger abgewandten Oberfläche der lichtempfindlichen Aufzeichnungsschicht auch noch eine Deckschicht oder Deckfolie angeordnet sein, die vorzugsweise in dem gleichen Entwickler-Lösungsmittel löslich ist wie die lichtempfindliche Aufzeichnungsschicht, oder von dieser abziehbar ist. Diese Deckschicht bzw. Deckfolie dient vor allem dem Schutz der lichtempfindlichen Aufzeichnungsschicht bei der Lagerung und Handhabung der lichtempfindlichen Aufzeichnungselemente und gegebenenfalls auch als Sauerstoffsperre für die photopolymerisierbare Aufzeichnungs schicht. Als besonders geeignet haben sich z.B. Deckschichten aus Polyvinylalkoholen oder Polyvinylalkohol-Derivaten bzw. - insbesondere bei Photoresistfilmen - Deckfolien aus Polyolefinen, wie z.B. Polyethylen oder Polypropylen, erwiesen.

Die Herstellung der erfindungsgemäßen lichtempfindlichen Aufzeichnungselemente kann in an sich bekannter und üblicher Weise durch Herstellung einer homogenen Mischung der die lichtempfindliche Aufzeichnungsschicht bildenden Komponenten und schichtförmiges Aufbringen dieser Mischung auf den - gegebenenfalls mit einer Zwischenschicht versehenen - Träger erfolgen. Beispielsweise kann man die Komponenten der lichtempfindlichen Aufzeichnungsschicht rein mechanisch in einer geeigneten Mischvorrichtung, z.B. einem Mischer oder Extruder, homogen vermischen und diese Mischung, beispielsweise

durch Extrudieren, Kalandrieren oder Pressen, zu einer Schicht der gewünschten Dicke formen, die dann auf den Träger auflaminiert bzw. aufkaschiert wird. Vorteilhafterweise werden die lichtempfindlichen Aufzeichnungselemente jedoch hergestellt, indem man die Komponenten der lichtempfindlichen Aufzeichnungsschicht in einem geeigneten Lösungsmittel oder Lösungsmittelgemisch löst und diese Lösung durch Gießen, Tauchen, Sprühen oder andere bekannte Auftragstechniken in der gewünschten Schichtstärke auf den Träger aufbringt. Anschließend wird das Lösungsmittel in üblicher Weise entfernt und die lichtempfindliche Aufzeichnungsschicht getrocknet. Geeignete Lösungsmittel für das Mischen der Komponenten und Aufbringen der lichtempfindlichen Aufzeichnungsschicht auf den Träger sind u.a. niedere Alkohole, Ketone oder Ester, wie z.B. Methanol, Aceton, Methylethylketon, Ethylacetat und ähnliche, sowie Mischungen hiervon. Anschließend kann auf die lichtempfindliche Aufzeichnungsschicht gewünschtenfalls noch die Deckschicht oder Deckfolie aufgebracht werden.

Die erfindungsgemäßen lichtempfindlichen Aufzeichnungselemente eignen sich in vorteilhafter Weise für die Herstellung von Druckformen oder Resistmustern nach den hierfür an sich bekannten und üblichen Verfahren. Hierzu wird die lichtempfindliche Aufzeichnungsschicht - bei Photoresistfilmen und Schichtübertragungsmaterialien nach der Schichtübertragung auf das zu schützende Substrat - bildmäßig mit aktinischem Licht belichtet, wobei sich hierfür die üblichen Lichtquellen von aktinischem Licht, wie beispielsweise UV-Fluoreszenzröhren, Quecksilberhoch-, -mittel- oder -niederdruckstrahler, superaktinische Leuchtstoffröhren, Xenon-Impulslampen, aber auch UV-Laser, Argonlaser und ähnliche, eignen. Die von den Lichtquellen emittierte Wellenlänge soll im allgemeinen zwischen 230 und 450 nm, bevorzugt zwischen 300 und 420 nm, liegen und insbesondere auf die Eigenabsorption des in der photopolymerisierbaren Aufzeichnungsschicht enthaltenen Photoinitiators abgestimmt sein.

Durch die bildmäßige Belichtung mit dem aktinischen Licht wird in den belichteten Bereichen der Aufzeichnungsschicht eine Photopolymerisation ausgelöst, die zu einer Vernetzung in den belichteten Schichtbereichen und damit zu einer Löslichkeitsdifferenzierung zwischen den belichteten und unbelichteten Schichtbereichen führt. Nach der bildmäßigen Belichtung wird die Druckform bzw. das Resistmuster durch Auswaschen der unbelichteten, unvernetzten Bereiche der Aufzeichnungsschicht mit einer wäßrig-alkalischen Entwicklerlösung entwickelt. Das Entwickeln kann durch Waschen, Sprühen, Reiben, Bürsten etc. erfolgen. Die erfindungsgemäßen Aufzeichnungselemente zeigen dabei einen großen Entwicklungsspielraum und eine sehr geringe Überwaschempfindlichkeit. Als Entwicklerlösungen kommen wäßrigalkalische Lösungen in Betracht, die zur Einstellung des günstigsten pH-Wertes, im allgemeinen im Bereich von 8 bis 14, vorzugsweise im Bereich von etwa 9 bis 13, alkalisch reagierende Substanzen, wie z.B. Borax, Dinatriumhydrogenphosphat, Soda, Alkalihydroxide oder organische Basen, wie Di- oder Triethanolamin in Wasser gelöst, enthalten. Die wäßrig-alkalischen Entwicklerlösungen können auch Puffersalze, z.B. wasserlösliche Alkaliphosphate, -silikate, -borate, -acetate oder -benzoate enthalten. Als weitere Bestandteile der Entwicklerlösungen können Netzmittel, vorzugsweise anionische Netzmittel, und gegebenenfalls wasserlösliche Polymere, wie z.B. Natriumcarboxymethylcellulose, Polyvinylalkohol, Polynatriumacrylat und dergleichen, mitverwendet werden. Obwohl die erfindungsgemäßen Aufzeichnungselemente im allgemeinen mit rein wäßrig-alkalischen Entwicklerlösungen ausgewaschen werden, ist es selbstverständlich grundsätzlich möglich, wenn auch nicht erforderlich, daß die wäßrig-alkalischen Entwicklerlösungen auch noch geringe Zusätze an wasserlöslichen organischen Lösungsmitteln, wie z.B. aliphatischen Alkoholen, Aceton oder Tetrahydrofuran, enthalten.

Die erfindungsgemäßen lichtempfindlichen Aufzeichnungselemente zeichnen sich durch ihre guten Belichtungseigenschaften und gute Entwickelbarkeit in wäßrig-alkalischen Entwicklerlösungen aus, wodurch es möglich ist, auch sehr feine Bildelemente vorlagengetreu und sicher zu reproduzieren. Besonders hervorzuheben ist, daß die erfindungsgemäßen lichtempfindlichen Aufzeichnungsschichten auf metallischen oder metalloxidischen Untergründen eine hervorragende Haftung aufweisen und es bei der Entwicklung der bildmäßig belichteten Aufzeichnungsschicht nicht zur Ausbildung von Restschicht-Belägen in den ausgewaschenen Bereichen kommt. Ferner besitzen die Aufzeichnungselemente im belichteten, d.h. photovernetzten Zustand, eine sehr hohe Beständigkeit gegenüber wäßrigen Medien, wie sie beispielsweise bei der Verwendung von Druckformen oder Resistmustern zur Anwendung kommen. Die erfindungsgemäßen lichtempfindlichen Aufzeichnungsmaterialien eignen sich grundsätzlich für alle Anwendungsgebiete der Reprographie und optischen Informationsfixierung.

Die Erfindung wird durch die nachfolgenden Beispiele näher erläutert. Die in den Beispielen genannten Teile und Prozente beziehen sich, sofern nicht anders angegeben, auf das Gewicht.

Herstellung der Silan-Hydrolysate

Beispiel A

(2-Trimethoxysilylethyl)phosphonsäuredimethylester wurde wie in US-A-3 780 127 bzw. US-A-3 816 550 beschrieben in konzentrierter Salzsäure hydrolysiert. Nach Entfernen überschüssiger Salzsäure wurde das erhaltene Produkt mit Wasser auf eine Konzentration von 40 % verdünnt.

Beispiel B

7,0 Teile (3-Triethoxysilylpropyl)bernsteinsäureanhydrid wurden in 3 Teilen Wasser gelöst und 1 Stunde bei Raumtemperatur gerührt. Danach wurde mit Wasser auf eine Konzentration von 50 % verdünnt.

Beispiel 1

Ein Photoresistfilm wurde durch Mischen folgender Komponenten hergestellt:

| | | |
|---|---|---|
| ( 1) | 50 %ige Lösung (in Essigester eines Oligomeren (= Umsetzungsprodukt aus Bisphenol A-diglycidylether (5 Teile), Adipinsäure (1,2 Teile), Acrylsäure (1 Teil) und Phthalsäureanhydrid (2,5 Teile)) | 80,00 g |
| ( 2) | 28 %ige Lösung (in Aceton) eines Copolymeren aus Methylmethacrylat (60 %), N-Vinylpyrrolidon (30 %) und Methacrylsäure (10 %) mit einem K-Wert (nach Fikentscher) von 40 | 107,00 g |
| ( 3) | Butandioldiacrylat | 11,00 g |
| ( 4) | Trimethylolpropantriacrylat | 12,00 g |
| ( 5) | Di-tert.-butyl-p-kresol | 0,10 g |
| ( 6) | Sicometpatentblau 80E131 | 0,05 g |
| ( 7) | Benzophenon | 3,00 g |
| ( 8) | Michler's Keton | 0,15 g |
| ( 9) | Hexachlorxylol | 3,00 g |
| (10) | Kristallviolett-Leukobase | 0,50 g |
| (11) | Lösung aus Beispiel A | 2,50 g |

Die filtrierte Lösung wurde so auf eine 23 µm dicke Polyesterfolie gegossen, daß nach dem Ablüften des Lösungsmittels und Trocknen (3 min bei 80 °C) eine Trockenschichtdicke von 35 µm resultierte. Die so hergestellte photopolymerisierbare Resistschicht wurde bis zur Weiterverarbeitung dieses Photoresistfilms mit einer Polyethylenfolie abgedeckt. Zur Prüfung wurde die Polyethylenfolie entfernt, der Photoresist bei 80 bis 120 °C auf ein kupferkaschiertes Leiterplattensubstrat auflaminiert und bildmäßig mit aktinischem Licht durch ein Negativ belichtet, das 250 µm breite Linien im Abstand von 250 µm enthielt. Die laminierten Platten wurden bei 25 °C im Gelblicht gelagert. Nach vorher festgelegten Zeiträumen wurde von den zu prüfenden Platten die Polyesterfolie entfernt und die unbelichteten Teile bei 30 °C mit einer 1 %igen wäßrigen Soda-Lösung ausgewaschen. Zur Prüfung auf Restschicht wurden die Leiterplatten mit ammoniakalischer Kupferchlorid-Lösung unter standardisierten Bedingungen geätzt. Bewertet wurde die Fläche in %, bezogen auf die Gesamtfläche der unbelichteten Schicht, die durch Ätzen nicht entfernt werden konnte. Die laminierten Platten waren nach 1 Woche noch völlig frei von Restschicht. Nach 2 Wochen waren erst 50 % der Fläche von Restschicht bedeckt.

Vergleichsbeispiel

Zum Vergleich mit Beispiel 1 wurden Resistfilme analog zu Beispiel 1 hergestellt, wobei jedoch beim Herstellen der Ansatzlösung das in Beispiel A erhaltene Hydrolyseprodukt des (2-Trimethoxysilylethyl)-phosphonsäuredimethylesters nicht zugesetzt wurde. Unter analogen Prüfbedingungen wies diese Schicht bereits nach 3 Tagen eine 100 %ige Bedeckung mit Restschicht auf.

Beispiele 2 bis 7

Weitere Silane wurden auf ihre Wirksamkeit geprüft, indem Photoresistfilme analog zu Beispiel 1 hergestellt wurden, wobei jedoch statt des in Beispiel 1 verwendeten Hydrolyseprodukts des (3-Trimethoxysilylpropyl)phosphonsäuredimethylesters jeweils 0,1 g Glycidyloxypropyltriethoxysilan (Beispiel 2), (3-Triethoxysilylpropyl)bernsteinsäureanhydrid (Beispiel 3), (3-Trimethoxysilylpropyl)methacrylat (Beispiel 4), (3-Trimethoxysilyl propyl)ethylendiamin (Beispiel 5), [(3-Trimethoxysilylpropylamino)ethyl](benzyl)-ammoniumchlorid (Beispiel 6) bzw. 0,2 g der gemäß Beispiel B erhaltenen Lösung des Hydrolyseprodukts von (3-Triethoxysilylpropyl)bernsteinsäureanhydrid (Beispiel 7) zugesetzt wurden.

Die bei Gelblichtlagerung erhaltenen Ergebnisse sind in Tabelle 1 zusammengefaßt.

Tabelle 1

| (Angaben in % Restschicht) | 3 Tage | 1 Woche | 2 Wochen |
|---|---|---|---|
| Vergleichsbeispiel | 100 % | 100 % | 100 % |
| Beispiel 2 | 0 % | 0 % | 0 % |
| Beispiel 3 | 0 % | 0 % | 80 % |
| Beispiel 4 | 0 % | 0 % | 100 % |
| Beispiel 5 | 0 % | 0 % | 90 % |
| Beispiel 6 | 0 % | 0 % | 80 % |
| Beispiel 7 | 0 % | 0 % | 70 % |

Die Proben der Beispiele 1 und 2 sowie des Vergleichsbeispiels wurden zusätzlich einem Zeitraffertest bei 50°/70 % rel. Feuchte unterzogen. Nach 1 Tag wies das Vergleichsbeispiel 100 % Restschicht auf, Beispiel 1 20 % Restshicht und Beispiel 2 35 % Restschicht.

**Ansprüche**

1. Lichtempfindliche, negativ arbeitende, zur Herstellung von Resistmustern geeignete, wäßrig-alkalisch entwickelbare Aufzeichnungsschicht, die im wesentlichen besteht aus einem Gemisch aus a) einem oder mehreren in Wasser unlöslichen, in wäßrig-alkalischen Lösungen jedoch löslichen oder zumindest dispergierbaren filmbildenden polymeren Bindemitteln,
b) einer oder mehreren photopolymerisierbaren organischen monomeren Verbindungen mit mindestens einer ethylenisch ungesättigten Doppelbindung oder einem Gemisch derartiger monomerer Verbindungen mit einer oder mehreren oligomeren Verbindungen mit mindestens einer ethylenisch ungesättigten Doppelbindung,
c) einem Photoinitiator oder Photoinitiatorsystem und
d) üblichen Zusatz- und Hilfsstoffen,
dadurch gekennzeichnet, daß das Gemisch zusätzlich ein Silan oder das bei der Hydrolyse des Silans entstehende Produkt oder Produktgemisch enthält.

2. Lichtempfindliche Aufzeichnungsschicht nach Anspruch 1, dadurch gekennzeichnet, daß als Silan mindestens eine Verbindung der allgemeinen Formel (I)

$X\text{-}(CH_2)_y\text{-}Si(R^1)_n(OR^2)_{3-n}$ (I),

worin $R^1$ und $R^2$ untereinander gleich oder verschieden sind und für Alkylreste mit 1 bis 9 Kohlenstoffatomen oder für Arylreste mit 6 bis 12 Kohlenstoffatomen stehen und X für einen der Reste

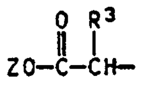 , 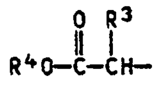 , 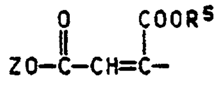 , 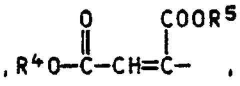 , 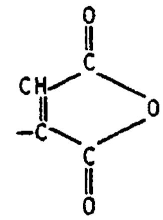 ,

$(R^5O)_2\overset{O}{\overset{\|}{P}}$-, $(Hal)_2\overset{O}{\overset{\|}{P}}$-, $ZO_3S$-, $HalO_2S$-, $ZO_3S$-Ar-, $HalO_2S$-Ar-, $R^5CH = CH$- $\overset{O}{\overset{\|}{C}}$ -O-,

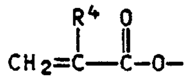 , 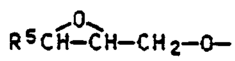 ,

$R^5NH-(CH_2)_sNH$- oder $[R^5NH_2-(CH_2)_sNH^{\oplus}]A^{\ominus}$
steht, wobei $R^3$ für Wasserstoff, einen Alkylrest mit 1 bis 9 Kohlenstoffatomen, einen Carbonsäurerest mit 1 bis 9 Kohlenstoffatomen oder einen aus diesem Carbonsäurerest und dem an $R^3$ gebundenen

HO- $\overset{O}{\overset{\|}{C}}$ - $\overset{|}{C}$ H-Rest

gebildeten Carbonsäureanhydridring steht,
$R^4$ für einen Alkylrest mit 1 bis 9 Kohlenstoffatomen oder einen Arylrest mit 6 bis 12 Kohlenstoffatomen steht,
$R^5$ für Wasserstoff, einen Alkylrest mit 1 bis 9 Kohlenstoffatomen oder einen Arylrest mit 6 bis 12 Kohlenstoffatomen oder einen Benzylrest steht,
Z für Wasserstoff oder ein Alkalimetall,
Ar für einen Arylenrest mit 6 bis 12 Kohlenstoffatomen,
Hal für Chlor oder Brom,
$A^{\ominus}$ für ein einwertiges anorganisches Anion,
s für eine ganze Zahl von 1 bis 6,
y für eine ganze Zahl von 1 bis 4 und
n = 0, 1 oder 2
stehen, eingesetzt wird.

3. Lichtempfindliche Aufzeichnungsschicht nach Anspruch 1, dadurch gekennzeichnet, daß sie das bei der Hydrolyse eines Silans nach Anspruch 2 erhaltene Produkt bzw. Produktgemisch enthält.

4. Lichtempfindliche Aufzeichnungsschicht nach einem der vorhergehenden Ansprüche, dadurch gekennzeichnet, daß das Silan oder dessen Hydrolyseprodukt in einer Konzentration von 0,01 bis 10 Gew.%, bezogen auf die Gesamtmenge der Aufzeichnungsschicht, eingesetzt wird.